(19) Europäisches Patentamt
European Patent Office
Office européen des brevets

(11) **EP 3 113 889 B1**

(12) **EUROPÄISCHE PATENTSCHRIFT**

(45) Veröffentlichungstag und Bekanntmachung des Hinweises auf die Patenterteilung:
**29.07.2020 Patentblatt 2020/31**

(21) Anmeldenummer: **14809420.4**

(22) Anmeldetag: **10.12.2014**

(51) Int Cl.:
*B06B 3/02* (2006.01)     *G01H 9/00* (2006.01)
*B23K 20/10* (2006.01)

(86) Internationale Anmeldenummer:
**PCT/EP2014/077195**

(87) Internationale Veröffentlichungsnummer:
**WO 2015/131968 (11.09.2015 Gazette 2015/36)**

(54) **VORRICHTUNG ZUR MESSUNG DER SCHWINGUNGSAMPLITUDE EINER KAPILLARE EINES DRAHT-BONDERS**

DEVICE FOR MEASURING THE VIBRATION AMPLITUDE OF A CAPILLARY OF A WIRE BONDER

DISPOSITIF SERVANT À MESURER L'AMPLITUDE D'OSCILLATION D'UN CAPILLAIRE D'UN SYSTÈME DE LIAISON PAR FIL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.03.2014 DE 102014204205**

(43) Veröffentlichungstag der Anmeldung:
**11.01.2017 Patentblatt 2017/02**

(73) Patentinhaber: **Dr. Johannes Heidenhain GmbH 83301 Traunreut (DE)**

(72) Erfinder:
• **HUBER, Walter**
**83278 Traunstein (DE)**
• **HOLZAPFEL, Wolfgang**
**83119 Obing (DE)**

(56) Entgegenhaltungen:
**DE-A1- 10 309 694     US-A- 5 431 324**
**US-B1- 6 827 247**

**Beschreibung**

BEZEICHNUNG DER ERFINDUNG

Vorrichtung zur Messung der Schwingungsamplitude einer Kapillare eines Draht-Bonders

GEBIET DER TECHNIK

Die vorliegende Erfindung betrifft eine Vorrichtung zur Messung der Schwingungsamplitude einer Kapillare eines Draht-Bonders gemäß dem Oberbegriff von Anspruch 1.

STAND DER TECHNIK

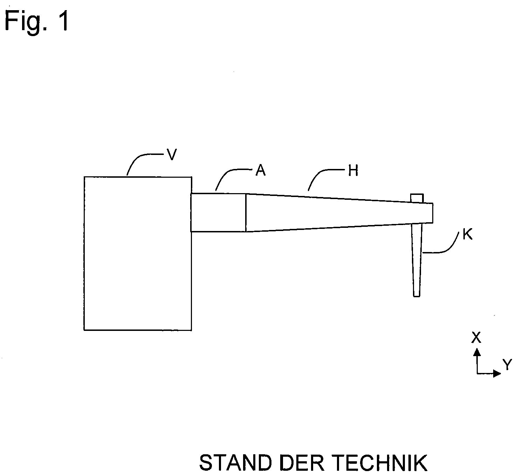

Mit Hilfe von Draht-Bondern werden üblicherweise Halbleiter-Bauelemente nach deren Montage auf ein Trägersubstrat verdrahtet bzw. elektrisch kontaktiert. In Figur 1 ist eine stark schematisierte Teil-Darstellung eines derartigen Draht-Bonders gezeigt. Ein Piezo-Aktuator A erzeugt im Draht-Bonder eine axiale Ultraschall-Welle mit einer Frequenz von ca. 100 kHz. Über ein Ultraschallhorn H wird diese Ultraschallwelle auf eine Kapillare K übertragen, die damit ebenfalls überwiegend in Achsrichtung Y des Ultraschallhorns H mit einer Amplitude von typisch 1-10 $\mu$m schwingt (kontaktloser Zustand). Übliche Durchmesser der Kapillare K liegen im Bereich zwischen 60$\mu$m und 150$\mu$m. Die zumeist aus Keramikmaterial ausgebildete Kapillare K besitzt einen - in der Figur nicht gezeigten - kleinen Kanal, durch den der Bonddraht geführt wird und der an der Spitze der Kapillare K austritt. Der sogenannte Bondkopf, bestehend aus dem Piezo-Aktuator A, dem Ultraschallhorn H und der Kapillare K, ist meist auf einer Verschiebeeinheit V im Draht-Bonder montiert. Die Verschiebeeinheit V kann den Bondkopf in allen drei Raumrichtungen X, Y, Z bewegen und damit die Kapillare K bzw. den Bonddraht an die einzelnen Kontaktstellen bringen.

Da die Kapillaren im Gebrauch verschleißen, müssen sie regelmäßig ausgetauscht werden. Nach dem Austausch besitzt die Kapillare meist eine leicht veränderte Schwingungsamplitude, da die verschiedenen Kapillaren in der Regel kleine mechanische Toleranzen aufweisen und auch deren Klemmung am Ultraschallhorn nicht vollständig reproduzierbar ist. Eine geänderte Schwingungsamplitude führt beim Draht-Bonden jedoch zu schwankenden Bondqualitäten. Die in der Regel erfolgende zeitaufwändige Optimierung des Bondprozesses mit einer ersten Kapillare ist damit nur sehr eingeschränkt auf die nachfolgend eingesetzten Kapillaren des gleichen Typs übertragbar. Das führt in der Praxis dazu, dass mit nicht vernachlässigbarer Wahrscheinlichkeit schlechte Bondkontakte produziert werden, die ein hohes Ausfallrisiko für das entsprechende elektronische Gerät darstellen.

Aus diesem Grund ist deshalb üblicherweise vorgesehen, nach jedem Wechsel der Kapillare die Schwingungsamplitude im kontaktlosen Zustand mithilfe einer geeigneten Vorrichtung neu zu messen und sie durch eine Anpassung der Speisespannung des Piezo-Aktuators wieder auf den optimierten Wert zu bringen. Auf diese Art und Weise kann die Bondqualität erheblich gesteigert werden.

Zur Messung der Schwingungsamplitude von Kapillaren eines Draht-Bonders sind Vorrichtungen bekannt, in denen die Kapillare zwischen einer Lichtquelle und einer Detektoranordnung platziert ist. Aus der Abschattung eines Strahlenbündels durch die Kapillare ist hierbei die Schwingungsamplitude bestimmbar. In Bezug auf derartige, auf einem Lichtschranken-Prinzip basierende Vorrichtungen sei etwa auf die Druckschriften EP 1 340 582 A1, US 6,827,247 B1, US 5, 431, 324 A und JP 10-209199 A verwiesen. In der US 6,827,247 B1 ist hierbei vorgesehen, die beiden Kanten der Kapillare gleichzeitig abzutasten und daraus die Schwingungsamplitude zu bestimmen; bei den bekannten Vorrichtungen aus den Druckschriften EP 1 340 582 A1, und JP 10-209199 A wird jeweils nur eine Kante der Kapillare zu diesem Zweck abgetastet. In der US 5, 431, 324 A ist vorgesehen, dass zwischen der Bildebene und der Detektoranordnung eine zweite Abbildungsoptik angeordnet ist, über die eine Fokussierung des Messstrahlenbündels und des Referenzstrahlenbündels in eine Detektionsebene oder in eine Blendenebene erfolgt.

In den aus diesen Dokumenten bekannten Vorrichtungen wird jeweils das an der Detektoranordnung erzeugte Ausgangssignal durch die Ultraschall-Bewegung der Kapillare leicht moduliert. Die Modulationsamplitude $\Delta S_{AC}$ des Ausgangssignals hängt hierbei näherungsweise linear mit der Schwingungsamplitude $\Delta y_{AC}$ der Kapillare zusammen gemäß nachfolgender Beziehung:

$$\Delta S_{AC} = \eta \cdot \Delta y_{AC} \quad \text{(Gl. 1)}$$

mit:

$\Delta S_{AC}$ := Modulationsamplitude des Ausgangssignals
$\Delta y_{AC}$ := Schwingungsamplitude der Kapillare
$\eta$ := Steigungsfaktor

Der Steigungsfaktor $\eta$ ist abhängig von der Lichtleistung der verwendeten Lichtquelle, von der Größe des Lichtquellenbildes auf der Kapillare und vom Verstärkungsfaktor der Auswerteelektronik. Es ist deshalb erforderlich, den Steigungsfaktor $\eta$ zu kalibrieren, wobei dieser möglichst konstant sein sollte. Diese Forderung muss insbesondere auch in Bezug auf die Arbeitstemperatur gelten, da in einem Draht-Bonder üblicherweise keine konstanten Temperaturverhältnisse vorliegen, sondern je nach Auslastung der Maschine und Prozess z.T. erhebliche Temperaturschwankungen in einem Arbeitstemperaturbereich von 20°C bis zu 60°C auftreten können. Derartige Temperaturschwankungen haben bei den bisher bekannten Lösungen auch Schwankungen in der von der Lichtquelle abgegebenen Lichtleistung zur Folge. So resultiert bei einem vorausgesetzten, typischen Temperaturkoeffizienten der Lichtleistung einer Lichtquelle von -0,3%/K und einem Temperaturanstieg von 40K eine Reduzierung der abgegebenen Lichtleistung von 12%. Damit verändert sich auch der oben erwähnte Steigungsfaktor $\eta$ um 12%, was wiederum zu erheblichen Fehlern bei der Bestimmung der Schwingungsamplitude $\Delta y_{AC}$ der Kapillare führt. Die bekannten Vorrichtungen zur Messung der Schwingungsamplitude in Draht-Bondern besitzen deshalb nur eine begrenzte Genauigkeit.

Ein weiteres Problem stellt bei bekannten Vorrichtungen aus dem Stand der Technik das Rauschen des erzeugten Ausgangssignals dar. Grundsätzlich sollte ein derartiges Rauschen möglichst gering sein. Nur bei sehr kleinen Rauschwerten, sind die Schwingungsamplituden $\Delta y_{AC}$ mit der nötigen hohen Reproduzierbarkeit bestimmbar. In den Vorrichtungen aus den o.g. Dokumenten wird die transmittierte Lichtleistung mithilfe eines Photoelements in der Detektoranordnung gemessen, welche somit das Ausgangssignal der Lichtschranke darstellt, das anschließend noch verstärkt und digitalisiert wird. Am Arbeitspunkt der Lichtschranke bei etwa der halben Abdeckung des Lichtflecks durch die Kapillare müssen kleine Modulationsamplituden $\Delta S_{AC}$ auf einem hohen Signal-Offsetpegel $S_{DC}$ bestimmt werden, der dieser halben Abdeckung entspricht. Der verwendete Verstärker muss daher entsprechend ausgelegt sein, um den hohen Signal-Offsetpegel $S_{DC}$ verstärken zu können. Der Verstärkungsfaktor ist hierbei so zu wählen, dass der Offsetpegel $S_{DC}$ nicht zu einer Sättigung des Verstärkers führt. Durch die entsprechend geringe Verstärkung kann der Verstärker nicht rausch-optimiert eingesetzt werden. Folglich sind die Rauschpegel der aus den o.g. Dokumenten bekannten Vorrichtungen zur Messung der Schwingungsamplitude von Kapillaren in Draht-Bondern relativ hoch.

## ZUSAMMENFASSUNG DER ERFINDUNG

Der vorliegenden Erfindung liegt die Aufgabe zugrunde, eine Vorrichtung zur Messung der Schwingungsamplitude einer Kapillare eines Draht-Bonders zu schaffen, die auch bei großen Temperaturschwankungen weitgehend fehlerfrei funktioniert. Desweiteren sollte das damit erzeugte Ausgangssignal möglichst rauscharm sein.

Diese Aufgabe wird erfindungsgemäß durch eine Vorrichtung mit den Merkmalen des Anspruchs 1 gelöst.

Vorteilhafte Ausführungen der erfindungsgemäßen Vorrichtung ergeben sich aus den Maßnahmen, die in den abhängigen Ansprüchen aufgeführt sind.

Die erfindungsgemäße Vorrichtung dient zur Messung der Schwingungsamplitude einer Kapillare eines Draht-Bonders, wobei die Kapillare zwischen einer Lichtquelle und einer Detektoranordnung platziert ist. Aus der Abschattung eines Strahlenbündels durch die Kapillare ist die Schwingungsamplitude bestimmbar. Hierbei erfährt das von der Lichtquelle emittierte Strahlenbündel eine Aufspaltung in ein Messstrahlenbündel und ein Referenzstrahlenbündel, wobei eine Kante der Kapillare im schwingenden Zustand das Messstrahlenbündel mindestens teilweise abschattet, während das Referenzstrahlenbündel keine Abschattung erfährt. Die Detektoranordnung umfasst einen dem Messstrahlenbündel zugeordneten Messdetektor sowie mindestens einen dem Referenzstrahlenbündel zugeordneten Referenzdetektor; aus den miteinander verschalteten Ausgangssignalen des Messdetektors und des Referenzdetektors ist die Schwingungsamplitude der Kapillare bestimmbar.

Erfindungsgemäß ist der Lichtquelle in Strahlausbreitungsrichtung eine erste Abbildungsoptik nachgeordnet, über die eine Abbildung der Lichtquelle im Messstrahlenbündel und im Referenzstrahlenbündel in eine Bildebene erfolgt, in der die Kapillare schwingt.

Hierbei ist zwischen der Bildebene und der Detektoranordnung eine zweite Abbildungsoptik angeordnet, über die eine Fokussierung des Messstrahlenbündels und des Referenzstrahlenbündels in eine Detektionsebene oder in eine Blendenebene erfolgt.

Es ist möglich, dass die erste und/oder zweite Abbildungsoptik jeweils refraktive oder diffraktive Linsen umfasst, die im Messstrahlenbündel und im Referenzstrahlenbündel angeordnet sind.

Es kann ferner vorgesehen sein, dass die erste Abbildungsoptik derart ausgebildet ist, dass der Durchmesser des Lichtquellenbildes in der Bildebene kleiner als der zweifache Durchmesser der Kapillare ist. Weiterhin ist erfindungsgemäß benachbart zur Detektionsebene oder in der Blendenebene

- im Messstrahlenbündel eine Blendenöffnung angeordnet, der der Messdetektor in Strahlausbreitungsrichtung nachgeordnet ist und
- im Referenzstrahlenbündel eine Blendenöffnung angeordnet, der der mindestens eine Referenzdetektor in Strahlausbreitungsrichtung nachgeordnet ist.

Mit Vorteil weisen hierbei die Blendenöffnungen jeweils einen Durchmesser auf, der im Bereich des einfachen bis dreifachen Durchmessers der fokussierten Mess- und Referenzstrahlenbündel liegt.

Es kann ferner vorgesehen sein, dass der Messdetektor und mindestens ein Referenzdetektor antiparallel miteinander verschaltet sind, so dass an den ausgangsseitigen Anschlüssen ein Photostrom-Differenzsignal resultiert, welches einer nachgeordneten Transimpedanz-Verstärkerstufe zuführbar ist, welches das Photostrom-Differenzsignal verstärkt und in ein Spannungssignal umwandelt.

In einer weiteren Variante kann ein über den Referenzdetektor erzeugtes Referenzsignal zur Regelung der Intensität der verwendeten Lichtquelle dienen.

Ferner ist es möglich, dass die Detektoranordnung zwei Referenzdetektoren umfasst, wobei das erzeugte Referenzsignal eines Referenzdetektors zur Regelung der Intensität der verwendeten Lichtquelle dient.

Als besonders vorteilhaft erweist sich bei der erfindungsgemäßen Vorrichtung, dass nunmehr auch im Fall von schwankenden Temperaturen eine variierende Lichtleistung das Ausgangssignal nicht negativ beeinflusst, d.h. es ist auch bei schwankenden Temperaturen eine fehlerfreie Ermittlung der Schwingungsamplitude gewährleistet.

Desweiteren besitzt das erzeugte Ausgangssignal nur einen geringen Rauschanteil. Dadurch ist es möglich, neben der Grundwelle der Ultraschall-Bewegung der Kapillare auch deren Oberwellen mit entsprechend kleineren Schwingungsamplituden messtechnisch zu erfassen. Derartige Oberwellen sind sehr empfindlich bezüglich der mechanischen Anbindung der Kapillare, so dass aus der Kenntnis von Phase und Amplitude der Oberwellen wichtige Informationen gewinnbar sind.

Weitere Einzelheiten und Vorteile der vorliegenden Erfindung seien anhand der nachfolgenden Beschreibung von Ausführungsbeispielen der erfindungsgemäßen Vorrichtung in Verbindung mit den Figuren erläutert.

## KURZE BESCHREIBUNG DER ZEICHNUNGEN

Es zeigt

Figur 1    eine stark schematisierte Teildarstellung eines Draht-Bonders gemäß dem Stand der Technik;

Figur 2    eine schematisierte Darstellung eines ersten Ausführungsbeispiels der erfindungsgemäßen Vorrichtung;

Figur 3    eine Darstellung der Kapillare und des teilweise abgeschatteten Messstrahlenbündels im ersten Ausführungsbeispiel;

Figur 4    eine schematisierte Darstellung zur Signalverarbeitung im ersten Ausführungsbeispiel;

Figur 5    den Verlauf verschiedener Signale im ersten Ausführungsbeispiel;

Figur 6    eine schematisierte Darstellung eines zweiten Ausführungsbeispiels der erfindungsgemäßen Vorrichtung;

Figur 7    die Signalverarbeitung zur Regelung der Lichtquellenintensität im zweiten Ausführungsbeispiel.

rungsbeispiel.

## BESCHREIBUNG DER AUSFÜHRUNGSFORMEN

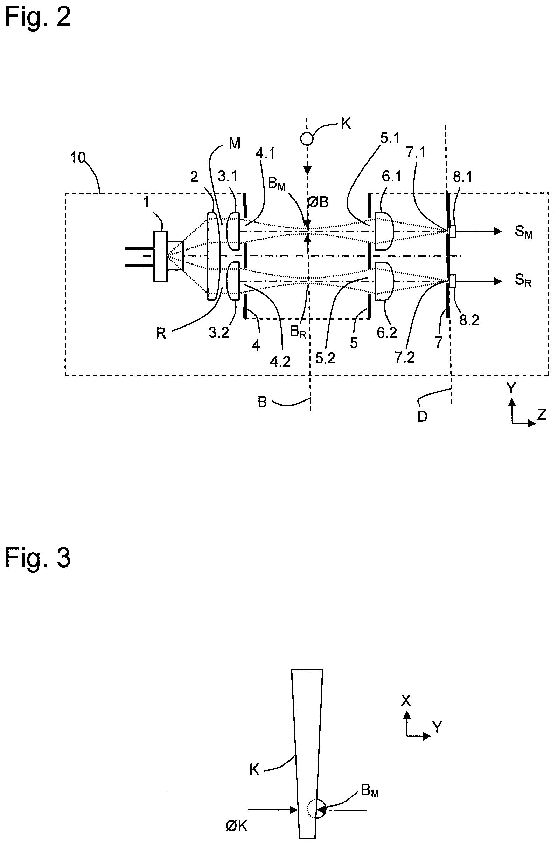

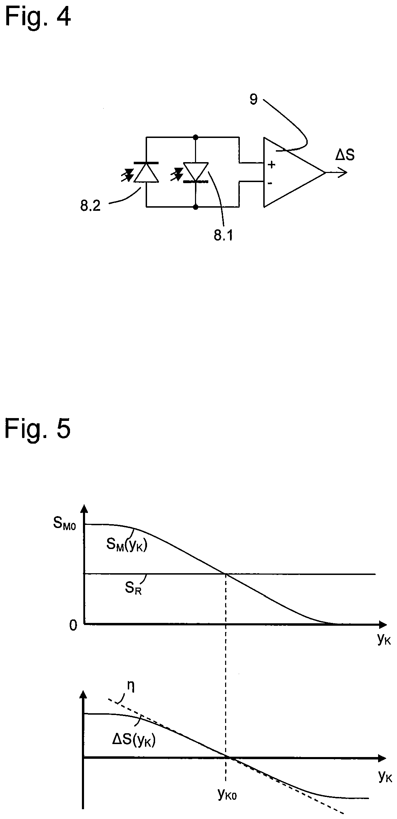

Ein erstes Ausführungsbeispiel der erfindungsgemäßen Vorrichtung zur Messung der Schwingungsamplitude einer Kapillare eines Drahtbonders wird nachfolgend anhand der Figuren 2 - 5 erläutert. Während Figur 2 hierbei eine schematisierte Darstellung eines ersten Ausführungsbeispiels der erfindungsgemäßen Vorrichtung zeigt, dienen die Ansichten der Kapillare und des Messstrahlenbündels in Figur 3, die Verschaltungs-Darstellung in Figur 4 sowie die verschiedenen gezeigten Signalverläufe in Figur 5 zur detaillierten Erläuterung des Funktionsprinzips dieses Ausführungsbeispiels.

Im dargestellten ersten Ausführungsbeispiel der erfindungsgemäßen Vorrichtung 10 ist eine Lichtquelle 1, z.B. ausgebildet als LED, vorgesehen, die ein Strahlenbündel emittiert, das über eine Kollimationslinse 2 kollimiert wird und anschließend eine Aufspaltung in ein Messstrahlenbündel M und ein Referenzstrahlenbündel R erfährt. Für eine derartige Aufspaltung ist vorliegend vorgesehen, im kollimierten Strahlenbündel eine erste Abbildungsoptik mit zwei Linsen 3.1, 3.2 anzuordnen, wobei eine Linse 3.1 dem Messstrahlenbündel M zugeordnet ist und die andere Linse 3.2 dem Referenzstrahlenbündel R. Die Linsen 3.1, 3.2 können hierbei sowohl als refraktive Linsen wie auch als diffraktive Linsen ausgebildet sein, die in geeigneter Art und Weise im Messstrahlenbündel M und im Referenzstrahlenbündel R angeordnet sind. Über die erste Abbildungsoptik bzw. die Linsen 3.1, 3.2 erfolgt in den jeweiligen Strahlenbündeln M, R jeweils eine Abbildung der Lichtquelle 1 in eine Bildebene B, in der die Lichtquellenbilder $B_M$ bzw. $B_R$ resultieren. Zur ersten Abbildungsoptik gehört im gezeigten Ausführungsbeispiel noch eine Blende 4 mit zwei Blendenöffnungen 4.1, 4.2, die in Strahlausbreitungsrichtung Z den Linsen 3.1, 3.2 nachgeordnet sind. Die Bildebene B stellt hierbei auch diejenige Ebene dar, in der die Kapillare K in der angegebenen Y-Richtung schwingt. Die Bildebene B stellt in den Figuren 1 - 3 somit die XY-Ebene dar, wobei mit X die Längserstreckungsrichtung der Kapillare bezeichnet sei. Wie aus Figur 2 ersichtlich, ist in der erfindungsgemäßen Vorrichtung dabei vorgesehen, dass die Kapillare K im schwingenden Zustand lediglich das Messstrahlenbündel M mindestens teilweise abschattet; der Strahlengang des Referenzstrahlenbündels R wird von der Kapillare K nicht abgeschattet. Für die erfolgende Abbildung über die Linsen 3.1, 3.2 der ersten Abbildungsoptik wird ein Abbildungsmaßstab m vorzugsweise gemäß m = 1 gewählt, alternativ kann auch m < 1 vorgesehen werden.

Hinter der Bildebene B propagieren das Messstrahlenbündel M und das Referenzstrahlenbündel R dann in Richtung einer zweiten Abbildungsoptik, die in Strahlausbreitungsrichtung Z aufeinanderfolgend eine Blende 5 mit zwei Blendenöffnungen 5.1, 5.2 sowie zwei Linsen 6.1, 6.2 in den jeweiligen Strahlengängen umfasst. Über die zweite Abbildungsoptik bzw. die Linsen 6.1, 6.2 erfolgt eine Fokussierung des Messstrahlenbündels M und des Referenzstrahlenbündels R in eine Detektionsebene D, in der eine weitere Blende 7 mit Blendenöffnungen 7.1, 7.2 in den beiden Strahlenbündeln M, R angeordnet ist. Der Blendenöffnung 7.1 im Messstrahlenbündel M ist hierbei der Messdetektor 8.1 und der Blendenöffnung 7.2 im Referenzstrahlenbündel R der Referenzdetektor 8.2 der Detektoranordnung unmittelbar benachbart nachgeordnet. Über den Messdetektor 8.1 resultiert hierbei ein Signal, das nachfolgend als Ausgangssignal $S_M$ bzw. Messsignal bezeichnet sein, am Ausgang des Referenzdetektors 8.2 resultiert das Ausgangssignal $S_R$; letzteres wird nachfolgend auch als Referenzsignal bezeichnet.

Zur Messung der Schwingungsamplitude mit Hilfe der erfindungsgemäßen Vorrichtung 10 wird nun die Kapillare K mithilfe einer in Figur 2 nicht gezeigten Verschiebeeinheit in die Nähe des Ortes des Lichtquellenbildes $B_M$ im Messstrahlenbündel M gebracht; dieser Ort sei nachfolgend auch als Antastort bezeichnet. Die Kapillare K wird hierbei soweit in das Messstrahlenbündel M in Y-Richtung eingeschoben, dass dieses etwa zur Hälfte abgedeckt wird, wie dies in Figur 3 veranschaulicht ist. Von Vorteil erweist sich hierbei, wenn der Durchmesser ØB des Lichtquellenbildes $B_M$ kleiner als der zweifache Durchmesser 2ØK der Kapillare K am Antastort ist, damit eine halbe Abdeckung bzw. Abschattung des Messstrahlenbündels M durch die Kapillare K überhaupt möglich ist.

Das im oberen Teil der Figur 5 dargestellte, am Messdetektor 8.1 resultierende Ausgangssignal $S_M(y_K)$, das von der Position $y_K$ der Kapillare K abhängt, sinkt an diesem Ort auch auf den halben Ausgangswert $S_{M0}$. Diese Position wird nachfolgend als nominelle Messposition $y_{K0}$ bezeichnet. Die Verschiebevorrichtung wird an diesem Ort angehalten. Das Ausgangssignal $S_R$ des Referenzdetektors R ist von der Schwingungsbewegung der Kapillare K unbeeinflusst und bleibt konstant auf einem bestimmten Signalpegel. Vorzugsweise wird im vorliegenden Ausführungsbeispiel der erfindungsgemäßen Vorrichtung das konstante Ausgangssignal $S_R$ des Referenzdetektors 8.2 so eingestellt, dass das Referenzsignal $S_R$ etwa halb so groß wie der Ausgangswert $S_{M0}$ des Ausgangssignals $S_M(y_K)$ des Messdetektors 8.1, also:

$$S_R = S_{M0}/2 \qquad (Gl.\ 2)$$

mit:

$S_R$ := Ausgangssignal des Referenzdetektors
$S_{M0}$ := Ausgangswert des Ausgangssignals des Messdetektors

Damit sind wie aus der oberen Signaldarstellung in Figur 5 ersichtlich die Ausgangssignale $S_M$, $S_R$

des Messdetektors 8.1 und des Referenzdetektors 8.2 an der nominellen Messposition $y_{K0}$ gleich groß.

Im Hinblick auf die weitere Signalverarbeitung im vorliegenden Ausführungsbeispiel der erfindungsgemäßen Vorrichtung sei auf die Figur 4 sowie die Signaldarstellungen in Figur 5 verwiesen. Wie aus Figur 4 ersichtlich, sind das Photoelement des Messdetektors 8.1 und das Photoelement des Referenzdetektors 8.2 antiparallel verschaltet, so dass an den beiden ausgangsseitigen Anschlüssen der gezeigten Schaltungsanordnung ein Photostrom-Differenzsignal $S_M - S_R$ resultiert. Das derart erzeugte Photostrom-Differenzsignal $S_M - S_R$ wird dann über eine nachgeordnete Transimpedanz-Verstärkerstufe 9 verstärkt und zu einem Spannungssignal $\Delta S$ gewandelt. Der Verlauf des Spannungssignals $\Delta S$ im Bereich der nominellen Messposition $y_{K0}$ ist im unteren Teil der Figur 5 gezeigt. An der nominalen Messposition $y_{K0}$ ist der Wert des Spannungssignals $\Delta S$ Null, d.h. es gilt $\Delta S(y_{k0}) = 0$.

Wird nun der Piezo-Aktuator im Draht-Bonder für die Erzeugung der Ultraschallwelle eingeschaltet, so moduliert das Spannungssignal $\Delta S$ um den Signalpegel Null mit einem Steigungsfaktor $\eta$ gemäß der eingangs erwähnten Gleichung (1).

Aus den miteinander verschalteten Ausgangssignalen $S_M$, $S_R$ des Messdetektors 8.1 und des Referenzdetektors 8.2 lässt sich auf diese Art und Weise somit die Schwingungsamplitude der Kapillare K zuverlässig bestimmen.

Über die erfindungsgemäße Lösung resultieren eine Reihe von Vorteilen. So kann etwa die Transimpedanz-Verstärkerstufe 9 so ausgelegt werden, dass nur kleine Stromsignale um Null herum ohne Offset verarbeitet werden müssen. Damit kann der Verstärkungsfaktor der Transimpedanz-Verstärkerstufe 9 wesentlich größer gewählt werden, was einen besonders hohen Steigungsfaktor $\eta$ und ein besonders geringes Rauschen zur Folge hat. Grundsätzlich kann der Verstärkungsfaktor so groß gewählt werden, dass die Transimpedanz-Verstärkerstufe 9 bereits in Sättigung geht, wenn keine Kapillare K in den Strahlengang des Messstrahlenbündels M eintaucht oder die Kapillare K das Messstrahlenbündel M vollständig abblockt. Weiterhin wird das Ausgangssignal $\Delta S$ nicht von der unvermeidlichen Drift großer Offsetwerte, wie sie im oben diskutierten Stand der Technik auftreten, beeinträchtigt. Beide Effekte ermöglichen eine deutliche höhere Reproduzierbarkeit der Schwingungsmessungen mit Hilfe der erfindungsgemäßen Vorrichtung.

Auch bei einer Temperaturänderung des Draht-Bonders resultieren in Verbindung mit der erfindungsgemäßen Vorrichtung Vorteile. Die bei Temperaturänderungen resultierende, veränderte Lichtleistung der Lichtquelle führt nun nicht mehr zu einem Signaloffset und damit zu einer anderen nominellen Messposition $y_{K0}$, was eine Beeinträchtigung der Messungs-Reproduzierbarkeit nach sich ziehen würde. Unvermeidbar ist jedoch, dass bei einer Temperaturänderung mit der Lichtleistung auch der Steigungsfaktor η verändert wird. Aus diesem Grund ist es vorteilhaft, die Lichtleistung der Lichtquelle mit Hilfe des Ausgangssignals $S_R$ des Referenzdetektors zu regeln. Eine derartige Regelung wird nachfolgend anhand des zweiten Ausführungsbeispiels der erfindungsgemäßen Vorrichtung im Detail beschrieben.

Maßgeblich für die verschiedenen Vorteile der erfindungsgemäßen Vorrichtung ist, dass das vorgesehene Referenzsignal $S_R$ nicht elektrisch erzeugt wird, sondern optisch, nämlich über die Detektion des Referenzstrahlenbündels R, das von derselben Lichtquelle stammt wie das Messstrahlenbündel M. Besonders vorteilhaft erweist sich dabei, das Referenzstrahlenbündel R möglichst symmetrisch zum Messstrahlenbündel M zu erzeugen. Damit können sich mögliche Fehlereinflüsse, wie z.B. die Drift von Bauteilen, weitgehend ähnlich auf die beiden Ausgangssignale $S_M$, $S_R$ des Mess- und Referenzdetektors 8.1, 8.2 auswirken und bei der Differenzbildung kompensieren.

Als weiterer Vorteil der erfindungsgemäßen Vorrichtung ist zu erwähnen, dass damit fehlerverursachendes Streulicht unterdrückt werden kann. So ist in einer vorteilhaften Variante derselbigen vorgesehen, dass die Blendenöffnungen 7.1, 7.2 der Blende 7 in der Detektionsebene D einen Durchmesser besitzen, der etwa im Bereich des doppelten bis dreifachen Durchmessers der fokussierten Strahlenbündel M, R liegt. Ferner liegen die Blendenöffnungen 7.1, 7.2 in der Brennebene der Linsen 6.1, 6.2 der zweiten Abbildungsoptik. In der YZ-Ebene sind die Blendenöffnungen 7.1, 7.2 desweiteren mittig vor dem unmittelbar nachgeordneten Messdetektor 8.1 bzw. Referenzdetektor 8.2 angeordnet. In Verbindung mit den Blendenöffnungen 5.1, 5.2 der Blende 5 ist gewährleistet, dass nur Licht, dessen Ausbreitungsrichtung innerhalb der Aperturwinkel der jeweiligen Linsen 6.1, 6.2 liegt, auch auf die zugehörigen Detektoren 8.1, 8.2 gelangt. Auf diese Weise ist sichergestellt, das Streulicht, welches unter größeren Winkeln einfällt als denen, die durch die detektorseitigen Mess- und Referenzaperturen vorgegeben sind, nicht auf den Messdetektor 8.1 bzw. Referenzdetektor 8.2 gelangt.

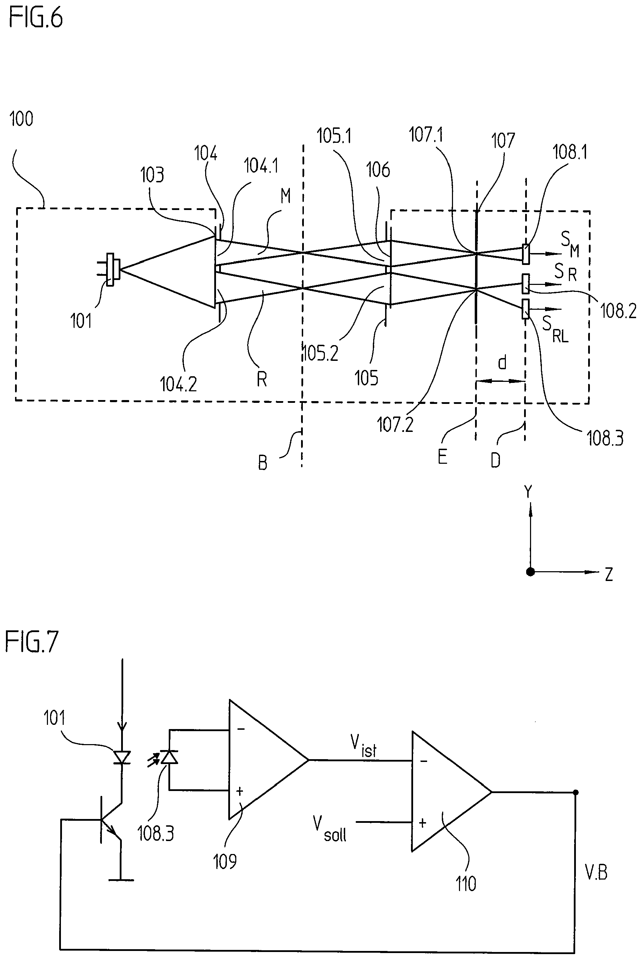

Ein zweites Ausführungsbeispiel der erfindungsgemäßen Vorrichtung 100 wird nachfolgend anhand der Figuren 6 und 7 beschrieben. Hierbei wird i.w. nur auf die maßgeblichen Unterschiede zum vorher erläuterten Ausführungsbeispiel eingegangen. Figur 6 zeigt hierbei wiederum eine schematisierte Darstellung desselbigen, Figur 7 die hier genutzte Signalverarbeitung zur Regelung der Lichtquellenintensität.

Über die erste Abbildungsoptik 103 und die Blende 104 erfolgt wie im obigen Beispiel eine Abbildung der Lichtquelle im Messstrahlenbündel M und im Referenzstrahlenbündel R in die Bildebene B. In der Bildebene B schwingt wiederum die hier nicht gezeigte Kapillare und schattet dabei zumindest teilweise das Messstrahlenbündel M ab. Über die Blende 105 und die zweite Abbildungsoptik 106 werden die Lichtquellenbilder aus der Bildebene B schließlich in die Blendenebene E mit den beiden Blendenöffnungen 107.1, 107.2 abgebildet, der im Abstand d der Messdetektor 108.1 und die zwei Referenzdetektoren 108.2, 108.3 nachgeordnet sind. Die erste und zweite Abbildungsoptik 103, 106 sind jeweils als 4-stufige diffraktive Linsen ausgebildet. Die beiden schematisch angedeuteten Blenden 104, 105 sind jeweils als absorbierende Dünnschichten auf Trägergläsern ausgebildet, auf denen auch die diffraktiven Linsen der ersten und zweiten Abbildungsoptik 103, 106 angeordnet sind; die Dünnschichten umschließen hierbei jeweils die diffraktiven Linsen der ersten und zweiten Abbildungsoptik 103, 106.

Im Unterschied zum vorherigen Ausführungsbeispiel wird das Referenzstrahlenbündel R detektionsseitig nunmehr über zwei Referenzdetektoren 108.2, 108.3 erfasst. Der erste Referenzdetektor 108.2 liefert das Referenzsignal $S_R$, das wie oben für die Erzeugung des Photostrom-Differenzsignals $S_M - S_R$ herangezogen wird. Durch die Aufteilung des Referenzstrahlenbündels R kann die oben genannte Bedingung gemäß Gl. 2 eingehalten werden. Der zweite Referenzdetektor 108.3 liefert ein zweites Referenzsignal $S_{RL}$, das zur oben bereits erwähnten Regelung der Intensität der verwendeten Lichtquelle 101 dient und auf diese Weise den Steigungsfaktor η bei Temperaturänderungen konstant hält.

Zu einer derartigen Regelung der Lichtquelle sei auf die Figur 7 verwiesen, die die dabei vorgesehene Signalverarbeitung beispielhaft veranschaulicht. Dem zweiten Referenzdetektor 108.3 ist hierbei ein Gleichlichtverstärker 109 und diesem wiederum ein Regelverstärker 110 und ein Regeltransistor 111 nachgeordnet. Die Regelung hält hierbei den Gleichstrom an den Eingängen des Gleichlichtverstärkers 109 konstant und kompensiert dadurch Änderungen der am Messdetektor 108.1 erfassten Signale, die z.B. durch die Alterung der Lichtquelle 101, und der Detektoren 108.1 - 108.3, durch die temperaturabhängige Detektorempfindlichkeit oder durch temperaturbedingte Änderung der Leuchtstärke der Lichtquelle entstehen können. Am nachgeordneten Regelverstärker 110 liegen eingangsseitig ein vorgegebener Signal-Sollwert $V_{SOLL}$ sowie das Ausgangssignal $V_{IST}$ des Gleichlichtverstärkers 109 an, die über den Regelverstärker 110 verglichen werden. Die Ausgangsspannung V.B des Regelverstärkers 110 ist mit der Basis des externen Regeltransistors verbunden, der den Lichtquellenstrom einstellt.

Neben den konkret beschriebenen Ausführungsbeispielen existieren im Rahmen der vorliegenden Erfindung selbstverständlich noch weitere Ausgestaltungsmöglichkeiten.

So ist beispielsweise möglich, anstelle der erläuterten Regelung der Lichtleistung der Lichtquelle gemäß dem zweiten Ausführungsbeispiel alternativ auch das Ausgangssignal $S_{RL}$ des zweiten Referenzdetektors 108.3 zu verwenden, um in einer alternativen Auswerteelektronik den Quotienten $(S_M - S_R) / S_{RL}$ aus den Signalen $S_M$, $S_R$, $S_{RL}$ zu berechnen. Bei einem Anstieg der Lichtleistung der Lichtquelle erhöhen bzw. erniedrigen sich die Signale $S_M$ - $S_R$ und $S_{RL}$ um den selben Faktor, so dass die Quotientenbildung ein von der Lichtleistung bzw. Temperatur unabhängiges Signal ($S_M$ - $S_R$) / $S_{RL}$ liefert.

Desweiteren existieren natürlich alternative Schaltungsanordnungen zur erläuterten Figur 4, um Differenzströme zu erzeugen, die einem Transimpedanzverstärker zugeführt werden.

Anstelle von LEDs können als Lichtquellen auch Laserdioden eingesetzt werden, insbesondere wenn sehr kleine Kapillaren im jeweiligen Draht-Bonder verwendet werden.

Neben einer einstufigen Abbildung der Lichtquelle in die Bildebene, kann selbstverständlich auch eine zwei- oder mehrstufige Abbildung vorgesehen werden; dies kann sowohl mit dem Abbildungsfaktor m = 1 oder aber mit Abbildungsfaktoren m < 1 erfolgen.

Ferner ist es möglich, anstelle der Verwendung zweier Referenzdetektoren wie im zweiten Ausführungsbeispiel auch das über lediglich einen Referenzdetektor erzeugte Ausgangssignal zur Regelung der Intensität der verwendeten Lichtquelle zu verwenden usw..

**Patentansprüche**

1. Vorrichtung zur Messung der Schwingungsamplitude einer Kapillare eines Draht-Bonders, wobei die Kapillare zwischen einer Lichtquelle und einer Detektoranordnung platziert ist und aus der Abschattung eines Strahlenbündels durch die Kapillare die Schwingungsamplitude bestimmt wird, wobei

   - das von der Lichtquelle (1; 101) emittierte Strahlenbündel eine Aufspaltung in ein Messstrahlenbündel (M) und ein Referenzstrahlenbündel (R) erfährt, wobei eine Kante der Kapillare (K) im schwingenden Zustand das Messstrahlenbündel (M) mindestens teilweise abschattet, während das Referenzstrahlenbündel (R) keine Abschattung erfährt und
   - die Detektoranordnung einen dem Messstrahlenbündel (M) zugeordneten Messdetektor (8.1; 108.1) sowie mindestens einen dem Referenzstrahlenbündel (R) zugeordneten Referenzdetektor (8.2; 108.2, 108.3) umfasst und aus den miteinander verschalteten Ausgangssignalen ($S_M$, $S_R$) des Messdetektors (8.1; 108.1) und des Referenzdetektors (8.2; 108.2, 108.3) die Schwingungsamplitude der Kapillare (K) bestimmt wird
   **dadurch gekennzeichnet, dass**
   - der Lichtquelle (1; 101) in Strahlausbreitungsrichtung (Z) eine erste Abbildungsoptik nachgeordnet ist, über die eine Abbildung der Lichtquelle (1; 101) im Messstrahlenbündel (M) und im Referenzstrahlenbündel (R) in eine Bildebene (B) erfolgt, in der die Kapillare (K) schwingt und

   - zwischen der Bildebene (B) und der Detektoranordnung eine zweite Abbildungsoptik angeordnet ist, über die eine Fokussierung des Messstrahlenbündels (M) und des Referenzstrahlenbündels (R) in eine Detektionsebene (D) oder in eine Blendenebene (E) erfolgt und
   - benachbart zur Detektionsebene (D) oder in der Blendenebene (E)

     - im Messstrahlenbündel (M) eine Blendenöffnung (7.1; 107.1) angeordnet ist, der der Messdetektor (8.1; 108.1) in Strahlausbreitungsrichtung (Z) nachgeordnet ist und
     - im Referenzstrahlenbündel (R) eine Blendenöffnung (7.2; 107.2) angeordnet ist, der der mindestens eine Referenzdetektor (8.2; 108.2, 108.3) in Strahlausbreitungsrichtung (Z) nachgeordnet ist.

2. Vorrichtung nach Anspruch 1, **dadurch gekennzeichnet, dass** die erste und/oder zweite Abbildungsoptik jeweils refraktive oder diffraktive Linsen (3.1, 3.2, 6.1, 6.2; 103, 106) umfasst, die im Messstrahlenbündel (M) und im Referenzstrahlenbündel (R) angeordnet sind.

3. Vorrichtung nach Anspruch 1, **dadurch gekennzeichnet, dass** die erste Abbildungsoptik derart ausgebildet ist, dass der Durchmesser des Lichtquellenbildes (ØB) in der Bildebene (B) kleiner als der zweifache Durchmesser (ØK) der Kapillare (K) ist.

4. Vorrichtung nach Anspruch 1, **dadurch gekennzeichnet, dass** die Blendenöffnungen (7.1, 7.2; 107.1, 107.2) jeweils einen Durchmesser aufweisen der im Bereich des einfachen bis dreifachen Durchmessers der fokussierten Mess- und Referenzstrahlenbündel (M, R) liegt.

5. Vorrichtung nach mindestens einem der vorhergehenden Ansprüche, **dadurch gekennzeichnet, dass** der Messdetektor (8.1) und mindestens ein Referenzdetektor (8.2) antiparallel miteinander verschaltet sind, so dass an den ausgangsseitigen Anschlüssen ein Photostrom-Differenzsignal ($S_M$ - $S_R$) resultiert, welches einer nachgeordneten Transimpedanz-Verstärkerstufe (9) zuführbar ist, welches das Photostrom-Differenzsignal ($S_M$ - $S_R$) verstärkt und in ein Spannungssignal ($\Delta S$) umwandelt.

6. Vorrichtung nach mindestens einem der vorhergehenden Ansprüche, **dadurch gekennzeichnet, dass** ein über den Referenzdetektor (8.2) erzeugtes Referenzsignal ($S_R$) zur Regelung der Intensität der verwendeten Lichtquelle (1) dient.

7. Vorrichtung nach mindestens einem der Ansprüche 1 - 5, **dadurch gekennzeichnet, dass** die Detektoranordnung zwei Referenzdetektoren (108.2, 108.3) umfasst, wobei das erzeugte Referenzsignal ($S_{RL}$) eines Referenzdetektors (108.3) zur Regelung der Intensität der verwendeten Lichtquelle (101) dient

## Claims

1. Device for measuring the oscillation amplitude of a capillary of a wire bonder, wherein the capillary is positioned between a light source and a detector arrangement, and the oscillation amplitude is determined from blocking a beam with the capillary, wherein

     - the beam emitted by the light source (1; 101) is divided into a measurement beam (M) and a reference beam (R), wherein an edge of the capillary (K) in the oscillating state at least partially blocks the measurement beam (M), while the reference beam (R) experiences no blocking and
     - the detector arrangement comprises a measurement detector (8.1; 108.1) assigned to the measurement beam (M) and at least, one reference detector (8.2; 108.2, 108.3) assigned to the reference beam (R) and the oscillation amplitude of the capillary (K) is determined from the output signals ($S_M$, $S_R$) of the measurement detector (8.1; 108.1) and of the reference detector (8.2; 08.2, 133.3), said signals being interconnected with each other,

     **characterized in that**

     - a first imaging optical unit is arranged downstream of the light source (1; 101) in a beam propagation direction (Z), by means of which first imaging optical unit the light source (1; 101) is imaged into an image plane (B), in which the capillary (K) oscillates, in the measurement beam (M) and in the reference beam (R) and
     - a second imaging optical unit is arranged between the image plane (B) and the detector arrangement, by means of which second imaging optical unit the measurement beam (M) and the reference beam (R) are focused into a detection plane (D) or into a stop plane (E) and,
     - neighbouring the detection plane (D) or in the stop plane (E),
     - an aperture (7.1; 107.) is arranged in the measurement beam (M), the measurement detector (8.1 108.1) being arranged downstream of said aperture in the beam propagation direction (Z) and
     - an aperture (7.2; 107.2) is arranged in the reference beam (R), the at least one reference detector (8.2; 108.2, 108,3) being arranged downstream of said aperture in the beam ion direction (Z).

2. Device according to Claim 1, **characterized in that** the first and/or second imaging optical unit each comprise refractive or diffractive lenses (3.1, 3.2, 6.1, 6.2; 103, 106), which are arranged in the measurement beam (M) and in the reference beam (R).

3. Device according to Claim 1, **characterized in that** the first imaging optical unit is embodied in such a way that the diameter of the light source image (ØB) in the image plane (B) is smaller than twice the diameter (ØK) of the capillary (K).

4. Device according to Claim 1, **characterized in that** the apertures (7.1, 7.2; 107.1, 107.2) each have a diameter which lies in the range of one to three times the diameter of the focused measurement and reference beams (M, R).

5. Device according to at least one of the preceding claims, **characterized in that** the measurement detector (8.1) and at least one reference detector (8.2) are interconnected with each other in antiparallel fashion so that as a result there is a photocurrent difference signal ($S_M - S_R$) at the output-side ports, which is suppliable to a transimpedance amplifier stage (9) arranged downstream, which amplifies the photocurrent difference signal ($S_M - S_R$) and converts it into a voltage signal ($\Delta S$).

6. Device according to at least one of the preceding claims, **characterized in that** a reference signal ($S_R$) generated by the reference detector (8.2) serves for closed-loop control of the intensity of the used light source (1).

7. Device according to at least one of Claims - 5, **characterized in that** the detector arrangement comprises two reference detectors (108.2, 108.3), wherein the generated reference signal ($S_{RL}$) of a reference detector (108.3) serves for closed-loop control of the intensity of the used light source (101).

## Revendications

1. Dispositif servant à mesurer l'amplitude d'oscillation d'un capillaire d'un système de liaison par fil, dans lequel le capillaire est placé entre une source de lumière et un ensemble détecteur et l'amplitude d'oscillation est déterminée à partir de l'occultation d'un faisceau de rayons par le capillaire, dans lequel

     - le faisceau de rayons émis par la source de lumière (1 ; 101) est divisé en un faisceau de rayons de mesure (M) et un faisceau de rayons de référence (R), dans lequel une arête du capillaire (K), dans l'état D'oscillat ion, occulte au moins en partie le faisceau de rayons de mesure (M), tandis que le faisceau de rayons de référence (R) ne subit aucune occultation, et

- l'ensemble détecteur comprend un détecteur de mesure (8.1 ; 108.1) associé au faisceau de rayons de mesure (M) ainsi qu'au moins un détecteur de référence (8.2 ; 108.2, 108.3) associé au faisceau de rayons de référence (R), et l'amplitude d'oscillation du capillaire (K) est déterminée à partir des signaux de sortie ($S_M$, $S_R$) connectés les uns aux autres du détecteur de mesure (8.1 ; 108.1) et du détecteur de référence (8.2 ; 108.2, 108.3), **caractérisé en ce que**

- la source de lumière (1 ; 101) est suivie, dans la direction de propagation du faisceau (Z), par un premier système optique de formation d'image au moyen duquel une image de la source de lumière (1 ; 101) est formée dans le faisceau de rayons de mesure (M) et dans le faisceau de rayons de référence (R) dans un plan image (B) dans lequel oscille le capillaire (K) et

- il est prévu entre le plan image (B) et l'ensemble détecteur un deuxième système optique de formation d'image au moyen duquel le faisceau de rayons de mesure (M) et le faisceau de rayons de référence (R) sont focalisés dans un plan de détection (D) au dans un plan de diaphragme (E) et

- à proximité du plan de détection (D) ou dans le plan de diaphragme (E),

- il est prévu dans le faisceau de mesure (M) une ouverture de diaphragme (7.1 ; 107.1) qui est suivie par le détecteur de mesure (8.1; 108.1) dans la direction de propagation du faisceau (Z) et

- il est prévu dans le faisceau de référence (R) une ouverture de diaphragme (7.2 ; 107.2) qui est disposée en aval dudit au moins un détecteur de référence (8.2 ; 108.2, 108.3) dans la direction de propagation du faisceau (Z).

2. Dispositif selon la revendication 1, **caractérisé en ce que** le premier et/ou le deuxième système optique de formation d'image comprennent chacun des lentilles réfractantes ou diffractantes (3.1, 3.2, 6.1, 6.2 ; 103, 106) qui sont disposées dans le faisceau de rayons de mesure (M) et dans le faisceau de rayons de référence (R) .

3. Dispositif selon la revendication 1, **caractérisé en ce que** le premier système optique de formation d'image est conçu de telle manière que le diamètre de l'image de la source de lumière (ØB) dans le plan image (B) soit inférieur à deux fois le diamètre (ØK) du capillaire (K).

4. Dispositif selon la revendication 1, **caractérisé en ce que** les ouvertures de diaphragme (7.1, 7.2 ; 107.1, 107.2) ont chacune un diamètre qui se situe dans la plage d'un à trois fois le diamètre des faisceaux de rayons de mesure et de référence focalisés (M, R).

5. Dispositif selon au moins l'une des revendications précédentes, **caractérisé en ce que** le détecteur de mesure (8.1) et au moins un détecteur de référence (8.2) sont montés en antiparallèle l'un par rapport à l'autre, de sorte qu'il en résulte aux bornes côté sortie un signal de différence de photocourant ($S_M$ - $S_R$) qui peut être envoyé à un étage amplificateur à transimpédance (9) disposé en aval, qui amplifie le signal de différence de photocourant ($S_M$ - $S_R$) et le convertit en un signal de tension ($\Delta S$).

6. Dispositif selon au moins l'une des revendications précédentes, **caractérisé en ce qu'**un signal de référence ($S_R$) généré par le détecteur de référence (8.2) sert à réguler l'intensité de la source de lumière (1) utilisée.

7. Dispositif selon au moins l'une des revendications 1 à 5, **caractérisé en ce que** le dispositif de détection comprend deux détecteurs de référence (108.2, 108.3), dans lequel le signal de référence généré ($S_{RL}$) d' un détecteur de référence (108.3) sert à réguler l'intensité de la source de lumière (101) utilisée.

# Fig. 1

STAND DER TECHNIK

# Fig. 2

# Fig. 3

Fig. 4

Fig. 5

FIG.6

FIG.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1340582 A1
- US 6827247 B1

- US 5431324 A
- JP 10209199 A